# DEMANDE DE BREVET EUROPEEN

(11) **EP 4 312 279 A1**
(43) Date de publication de la demande: **31.01.2024**
(21) Numéro de dépôt: 23187953.7
(22) Date de dépôt: 26.07.2023
(51) Int. Cl.: H01L 31/105, H01L 31/109, H01L 31/0224, H01L 31/18, G02B 6/42

(54) **PROCEDE DE FABRICATION D'UN DISPOSITIF OPTOELECTRONIQUE COMPORTANT UNE PHOTODIODE DE TYPE GERMANIUM SUR SILICIUM COUPLEE OPTIQUEMENT A UN GUIDE D'ONDE INTEGRE EN SI3N4**

(30) Priorité: 28.07.2022 FR 2207816
(71) Demandeur: Commissariat à l'énergie atomique et aux énergies alternatives, 75015 Paris (FR)
(72) Inventeur: SZELAG, Bertrand, 38054 GRENOBLE Cedex 09 (FR)
(74) Mandataire: INNOV-GROUP

(57) **Abrégé**

L'invention porte sur un procédé de fabrication d'un dispositif optoélectronique comportant une photodiode (2) de type germanium sur silicium couplée à un guide d'onde (3) en Si₃N₄. Le procédé comporte les étapes suivantes :
∘ réalisation d'un substrat semiconducteur (20), comportant un empilement semiconducteur de couches minces (23, 24, 25) destinées à former des portions (31, 32, 33) d'un plot semiconducteur (30) de la photodiode (2) ;
∘ réalisation d'un substrat photonique (10), comportant le guide d'onde (3) en Si₃N₄;
∘ report et collage du substrat semiconducteur (20) sur le substrat photonique (10) ;
∘ réalisation de la photodiode (2), par photolithographie et gravure de l'empilement semiconducteur (23, 24, 25) pour former le plot semiconducteur (30) alors situé au-dessus du guide d'onde (3).

## Description

### DOMAINE TECHNIQUE

Le domaine de l'invention est celui des dispositifs optoélectroniques comportant une photodiode de type germanium sur silicium et couplée optiquement à un guide d'onde réalisé à base d'un nitrure de silicium, et plus précisément en Si₃N₄.

### ÉTAT DE LA TECHNIQUE ANTÉRIEURE

Il existe un besoin de disposer de photodiodes à base de germanium, pour détecter un mode optique guidé ayant une longueur d'onde comprise notamment entre 1300 et 1550nm en fonction des applications visées, par exemple de télécom, les photodiodes étant couplées optiquement à un guide d'onde en nitrure de silicium stoechiométrique Si₃N₄. En effet, un tel matériau est transparent dans cette gamme spectrale et présente de très faibles pertes optiques en transmission.

Cependant, fabriquer un tel dispositif optoélectronique présente des difficultés liées notamment à des contraintes d'intégration. Ainsi, il peut être nécessaire d'effectuer un recuit à haute température, de l'ordre de 1000°C, pour réduire les pertes de propagation dans le guide en nitrure de silicium Si₃N₄, ce qui peut ne pas être compatible avec le budget thermique des composants actifs ayant été réalisés.

A ce titre, le document Lischke et al. intitulé Silicon nitride waveguide coupled 67+ GHz Ge photodiode for non-SOI PIC and ePIC platforms, 2019 IEEE International Electron Devices Meeting (IEDM), 2019, 33.2.1 - 33.2.4 décrit un dispositif optoélectronique comportant une photodiode à base de germanium couplée optiquement à un guide d'onde réalisé en un nitrure de silicium non stoechiométrique. Ici, le germanium de la portion d'absorption de la photodiode est épitaxié à partir d'un substrat massif de silicium (*bulk substrate,* en anglais), et le guide d'onde en SiN est alors réalisé au-dessus de la portion d'absorption en germanium. Le guide d'onde est réalisé par un dépôt chimique en phase vapeur assisté par plasma (PECVD) à basse température, de manière à respecter le budget thermique et ainsi à ne pas dégrader les portions dopées et les composants actifs ayant déjà été réalisés. Aussi, cette approche ne permet pas d'obtenir un guide d'onde en nitrure de silicium stoechiométrique Si₃N₄.

Une autre approche peut consister à réaliser le guide d'onde, alors en Si₃N₄, au-dessus d'un substrat de type silicium sur isolant (SOI), puis de réaliser la photodiode de type germanium sur silicium (Ge sur Si) à partir de ce même substrat SOI. Le document de Hu et al. intitulé 180 Gbit/s Si3N4-waveguide coupled germanium photodetector with improved quantum efficiency, Opt. Lett. 46, 6019 (2021) décrit un tel dispositif optoélectronique, où des guides d'onde en Si₃N₄ sont disposés de manière latérale et de part et d'autre de la portion d'absorption en germanium de la photodiode. Cependant, cette approche comporte de fortes contraintes d'intégration en termes de dimensionnement et de positionnement entre les différents éléments. A titre d'exemple, les risques de fuites des modes guidés dans la couche épaisse en silicium du substrat SOI restent importants, et peuvent venir dégrader les performances du dispositif optoélectronique.

### EXPOSÉ DE L'INVENTION

L'invention a pour objectif de remédier au moins en partie aux inconvénients de l'art antérieur, et plus particulièrement de proposer un procédé permettant de fabriquer un dispositif optoélectronique comportant une photodiode de type Ge sur Si couplée optiquement à un guide d'onde intégré en Si₃N₄. Le dispositif optoélectronique présente de bonnes performances, et le procédé permet de limiter voire d'écarter les contraintes d'intégration, en termes de budget thermique, de dimensionnement et de positionnement, mentionnées précédemment.

Pour cela, l'objet de l'invention est un procédé de fabrication d'un dispositif optoélectronique comportant une photodiode de type germanium sur silicium couplée optiquement à un guide d'onde en Si₃N₄, la photodiode comportant un plot semiconducteur formé d'une portion inférieure dopée réalisée à base de silicium dopé selon un premier type de conductivité, une portion supérieure dopée selon un deuxième type de conductivité opposé au premier type et réalisée à base de silicium et/ou de germanium, et est de préférence réalisée en silicium, et une portion intermédiaire d'absorption réalisée à base de germanium et située entre les portions inférieure et supérieure dopées suivant un axe d'épaisseur de la photodiode.

Selon l'invention, le procédé comporte les étapes suivantes :
- réalisation d'un substrat dit semiconducteur, comportant un empilement semiconducteur de couches minces destinées à former les portions du plot semiconducteur ;
- réalisation d'un substrat dit photonique, comprenant une couche support et comportant le guide d'onde en Si₃N₄; la réalisation dudit substrat comprenant une étape de réalisation du guide d'onde en un nitrure de silicium stoechiométrique Si3N4, suivie d'une étape de recuit du guide d'onde au moins égale à 1000°C ;
- report et collage du substrat semiconducteur sur le substrat photonique postérieurement à l'étape de recuit ;
- réalisation de la photodiode, par photolithographie et gravure de l'empilement semiconducteur pour former le plot semiconducteur alors situé au-dessus du guide d'onde.

Certains aspects préférés mais non limitatifs de ce procédé de fabrication sont les suivants.

Le procédé peut comporter, lors de l'étape de réalisation de la photodiode, une étape de réalisation de la portion supérieure dopée et de la portion intermédiaire d'absorption, par gravure localisée d'une couche mince supérieure dopée et d'une couche mince intermédiaire réalisée à base de germanium de l'empilement semiconducteur, avec arrêt de gravure sur une couche mince inférieure dopée de l'empilement semiconducteur destinée à former la portion inférieure dopée.

Le procédé peut comporter, après l'étape de réalisation de la portion supérieure dopée et de la portion intermédiaire d'absorption, une étape de réalisation d'espaceurs réalisés à base d'un matériau électriquement isolant, disposés contre les flancs de la portion intermédiaire d'absorption, et s'étendant sur une partie de la couche mince inférieure dopée ou de la portion inférieure dopée.

Le procédé peut comporter, après l'étape de réalisation de la portion supérieure dopée et de la portion intermédiaire d'absorption, une étape de réalisation de la portion inférieure dopée, par gravure localisée d'une couche mince inférieure dopée, de sorte que la portion inférieure dopée présente des parties latérales non recouvertes.

Le procédé peut comporter, après l'étape de réalisation de la portion inférieure dopée, une étape de réalisation de portions latérales conductrices, réalisées en un matériau électriquement conducteur, situées sur et au contact d'une face supérieure des parties latérales de la portion inférieure dopée, par siliciuration du matériau à base de silicium de la portion inférieure dopée.

Le procédé peut comporter une étape de réalisation d'une portion centrale conductrice, réalisée en un matériau électriquement conducteur, située sur et au contact d'une face supérieure de la portion supérieure dopée, celle-ci étant réalisée à base de silicium, par siliciuration du matériau à base de silicium de la portion supérieure dopée de manière simultanée à la siliciuration du matériau à base de silicium de la portion inférieure dopée.

Le procédé peut comporter une étape de dépôt d'une couche isolante d'encapsulation recouvrant le plot semiconducteur, puis une étape de réalisation de métallisation de contact comportant des vias conducteurs latéraux traversant la couche isolante d'encapsulation pour venir au contact des portions latérales conductrices.

Le procédé peut comporter, une étape de recouvrement de la couche support par une couche inférieure diélectrique qui présente une épaisseur d'au moins 2 µm pour éviter les fuites optiques en direction de la couche support.

L'invention porte également sur un dispositif optoélectronique comportant :
- une photodiode de type germanium sur silicium, comportant un plot semiconducteur formé d'une formé d'une portion inférieure dopée réalisée à base de silicium, une portion supérieure dopée, et une portion intermédiaire d'absorption réalisée à base de germanium et située entre les portions inférieure et supérieure dopées suivant un axe d'épaisseur de la photodiode ;
- un guide d'onde en Si₃N₄, intégré et couplé optiquement à la photodiode.

Selon l'invention, le guide d'onde est situé en dessous de la photodiode suivant un axe d'épaisseur de la photodiode, et est intégré dans un substrat photonique sur lequel repose la photodiode ; le dispositif comprenant :
une couche supérieure diélectrique qui recouvre le guide d'onde intégré ainsi qu'une couche inférieure diélectrique sur laquelle repose le guide d'onde ,
de sorte que
le guide d'onde est couplé optiquement à la photodiode de manière évanescente via la couche diélectrique intermédiaire .

Le substrat photonique peut comporter une couche support et une couche inférieure diélectrique sur laquelle repose le guide d'onde, le guide d'onde étant espacé de la couche support d'au moins 2µm.

La portion inférieure dopée peut présenter une dimension transversale supérieure à celle de la portion intermédiaire d'absorption, des espaceurs réalisés à base d'un matériau électriquement isolant, disposés contre les flancs de la portion intermédiaire d'absorption, et s'étendant sur une partie de la face supérieure de la portion inférieure dopée.

Le dispositif optoélectronique peut comporter des portions latérales conductrices, réalisées en un siliciure, situées sur et au contact d'une face supérieure de parties latérales de la portion inférieure dopée non recouvertes par les espaceurs.

La portion supérieure dopée peut être réalisée à base de silicium. Le dispositif optoélectronique peut comporter une portion centrale conductrice, réalisées en un siliciure, située sur et au contact d'une face supérieure de la portion supérieure dopée.

Le dispositif optoélectronique peut comporter une couche isolante d'encapsulation recouvrant le recouvrant le plot semiconducteur et les portions latérales et centrale conductrices, et des métallisation de contact comportant des vias conducteurs latéraux traversant la couche isolante d'encapsulation pour venir au contact des portions latérales conductrices, et au moins un via conducteur centrale traversant la couche isolante d'encapsulation pour venir au contact de la portion centrale conductrice.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1 est une vue schématique et partielle, en coupe transversale, d'un dispositif optoélectronique comportant une photodiode de type Ge sur Si couplée optiquement à un guide d'onde intégré en Si₃N₄ disposé sous la photodiode, selon un mode de réalisation ;
les figures 2A à 2J illustrent différentes étapes d'un procédé de fabrication du dispositif optoélectronique selon un mode de réalisation, le dispositif optoélectronique étant similaire à celui illustré sur la fig.1.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un procédé de fabrication d'un dispositif optoélectronique, et sur le dispositif optoélectronique lui-même, qui comporte une photodiode de type germanium sur silicium, couplée optiquement à un guide d'onde intégré réalisé en Si₃N₄, c'est-à-dire en nitrure de silicium stoechiométrique.

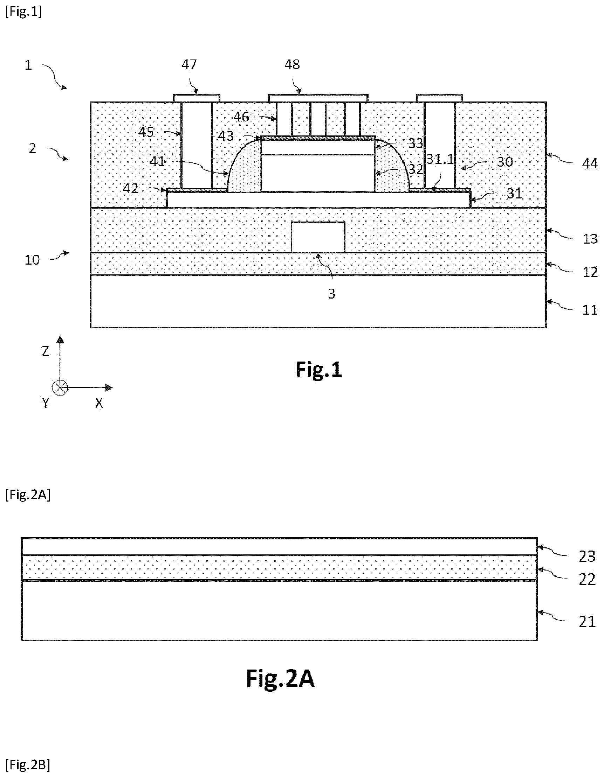

La figure 1 est une vue schématique et partielle, en coupe transversale, d'un tel dispositif optoélectronique 1 selon un mode de réalisation.

On définit ici et pour la suite de la description un repère direct tridimensionnel orthogonal XYZ, où le plan XY est un plan parallèle au plan du substrat photonique 10 et dans lequel s'étend le guide d'onde intégré 3, où l'axe longitudinal Y est orienté suivant l'axe de couplage optique de ce dernier avec la photodiode 2, et où l'axe vertical Z est orienté du guide d'onde intégré 3 vers la photodiode 2. Par ailleurs, les termes « inférieur » et « supérieur » s'entendent comme étant relatifs à un positionnement croissant suivant la direction +Z.

Le dispositif optoélectronique 1 comporte une photodiode 2 de type Ge sur Si, qui repose sur un substrat photonique 10 où est situé le guide d'onde intégré 3 en Si₃N₄.

Le substrat 10 est dit photonique dans la mesure où il comporte le guide d'onde 3 en Si₃N₄, qui est alors appelé guide d'onde intégré. Il peut comporter un circuit photonique intégré formé du guide d'onde 3 éventuellement couplé à d'autres guides d'onde.

Le substrat photonique 10 comporte ici une couche support 11, réalisé par exemple en un même matériau (par exemple en silicium, ici un substrat massif en silicium : *bulk silicon* en anglais) ou en un empilement de matériaux différents, et qui présente une épaisseur de l'ordre de plusieurs centaines de microns.

Une couche inférieure diélectrique 12 recouvre la couche support 11, et participe à former la gaine de bas indice de réfraction du guide d'onde intégré 3. Elle peut être réalisée en un oxyde, par exemple ici en un oxyde de silicium. Elle présente une épaisseur suffisante pour éviter les fuites optiques du mode guidé en direction de la couche support, par exemple d'au moins 2 µm, et de l'ordre de 2 à 3 µm.

Le guide d'onde intégré 3 repose donc sur la couche inférieure diélectrique 12. Il est réalisé en Si₃N₄, de sorte que les pertes optiques en transmission du mode guidé sont particulièrement faibles. Dans cet exemple, le guide d'onde intégré 3 est un guide droit (section transversale rectangulaire) mais, en variante, il peut être un guide en arête formé d'une base (*slab*) et d'une arête (rib). D'autres formes sont bien entendu possibles.

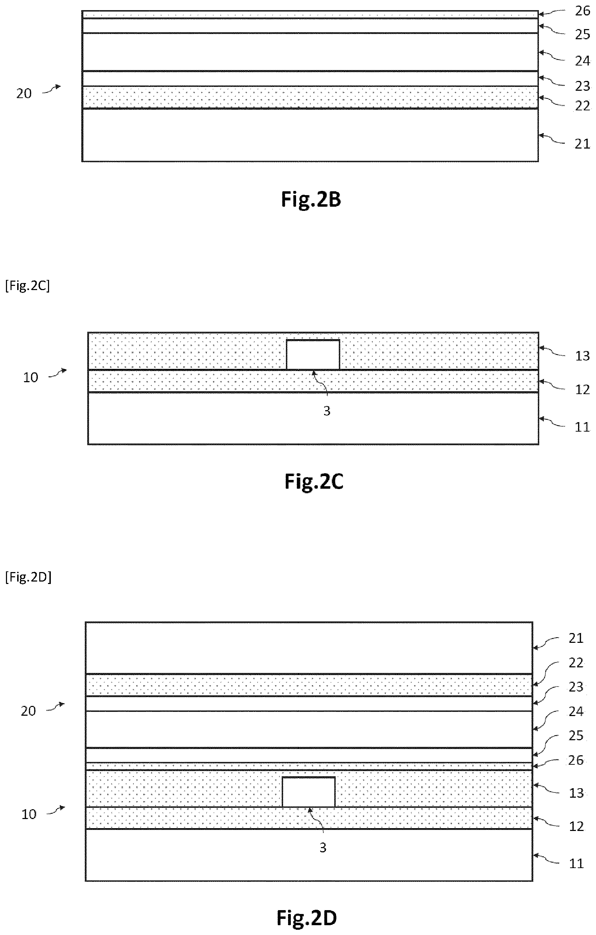

Une couche supérieure diélectrique 13 recouvre le guide d'onde intégré 3 ainsi que la couche inférieure diélectrique 12. Elle participe également à former la gaine du guide d'onde. Elle peut également être réalisée en un oxyde, par exemple ici en un oxyde de silicium. Dans cet exemple, elle définit la face supérieure du substrat photonique 10, et permet ici d'assurer le collage direct de type oxyde-oxyde avec une couche mince de collage 26 en oxyde (cf. fig.2D) du substrat semiconducteur 20 qui aura été reporté sur le substrat photonique 10. Elle permet également d'assurer un espacement vis-à-vis de la photodiode 2 pour permettre un bon couplage optique, ici par évanescence, avec la photodiode 2.

La photodiode 2 comporte un plot semiconducteur 30 formé de portions de couches minces semiconductrices 31, 32, 33. Plus précisément, le plot semiconducteur 30 comporte un empilement, suivant la direction +Z, d'une portion inférieure dopée 31, d'une portion intermédiaire d'absorption 32, et d'une portion supérieure dopée 33. Dans la mesure où la photodiode 2 est de type Ge sur Si, la portion intermédiaire d'absorption 32 est réalisée à base de germanium et la portion inférieure dopée 31 est réalisée à base de silicium dopé de type p.

La portion inférieure dopée 31 est réalisée à base de silicium dopé selon un premier type de conductivité, ici de type p. Dans cet exemple, elle est réalisée en silicium. Elle s'étend ici sur et au contact de la couche mince de collage 26 (cf. fig.2D). Elle présente une dimension transversale supérieure à celle des portions intermédiaire 32 et supérieure 33, de sorte qu'elle comporte au moins une partie latérale 31.1, et ici deux parties latérales, non recouvertes par ces dernières et qui s'étendent de part et d'autre, suivant l'axe X, des portions intermédiaire 32 et supérieure 33. Ces parties latérales 31.1 permettent de polariser électriquement la portion inférieure dopée 31 de manière latérale.

La portion intermédiaire d'absorption 32 est réalisée à base de germanium non intentionnellement dopé (intrinsèque ou présentant un léger dopage de type p). Dans cet exemple, elle est réalisée en germanium. Elle s'étend sur et au contact de la portion inférieure dopée 31 et présente une dimension transversale inférieure à cette dernière. Elle est le lieu d'absorption du mode optique à détecter, et présente une épaisseur adaptée à maximiser l'absorption. Le germanium présente ici des contraintes mécaniques en tension dans le plan XY, de sorte que la longueur d'onde de coupure d'absorption peut être ici au moins égale à 1550nm.

La portion supérieure dopée 33 est réalisée en un matériau semiconducteur dopé selon un deuxième type de conductivité opposé au premier type, ici de type n. Elle peut être réalisée à base de silicium et/ou de germanium, et est de préférence réalisée en silicium.

Dans un mode de réalisation, la photodiode 2 comporte des portions latérales conductrices 42, situées sur et au contact des parties latérales 31.1 de la portion inférieure dopée 31, et réalisées en un matériau électriquement conducteur, et ici en un siliciure. Elles améliorent le contact électrique entre la portion inférieure dopée 31 et les vias conducteurs 45.

Dans un mode de réalisation, la photodiode 2 comporte également des espaceurs 41, sous la forme de portions latérales isolantes, réalisés en un matériau électriquement isolant, par exemple un nitrure de silicium et/ou en orthosilicate de tétraéthyle (TEOS). Ces espaceurs 41 assurent une séparation physique, suivant l'axe X, entre les portions latérales conductrices 42 et la portion intermédiaire d'absorption 32.

Dans ce mode de réalisation où la portion supérieure dopée 33 est réalisée en silicium, une portion centrale conductrice 43 peut être située sur et au contact de cette dernière. Elle est réalisée en un matériau électriquement conducteur, et ici en un siliciure. Elle améliore le contact électrique entre la portion supérieure dopée 33 et le ou les vias conducteurs 46.

La photodiode 2 comporte une couche isolante d'encapsulation 44, qui recouvre le plot semiconducteur 30 et s'étend sur le substrat photonique 10. Des métallisations de contact sont prévues pour assurer la polarisation électrique de la photodiode 2, à savoir ici des vias conducteurs latéraux 45 et au moins un via conducteur central 46, qui s'étendent au travers de la couche isolante d'encapsulation 44 pour venir ici au contact, respectivement, des portions latérales conductrices 42 et de la portion centrale conductrice 43. Des plots conducteurs 47, 48 peuvent être prévus sur et au contact des extrémités supérieures des vias conducteurs 45, 46 pour faciliter la connexion électrique.

Le dispositif optoélectronique 1 comporte donc une photodiode 2 de type Ge sur Si couplée optiquement par évanescence à un guide d'onde intégré 3 en Si₃N₄ situé sous la photodiode 2, et plus précisément à la verticale de la portion intermédiaire d'absorption 32. Ainsi, le dispositif optoélectronique 1 présente de bonnes performances du fait que le guide d'onde intégré 3 est réalisé en Si₃N₄ d'une part et qu'un recuit à haute température (au moins 1000°C, par exemple 1000°C ou 1100°C environ) a pu être effectué (sans engendrer de dégradation vis-à-vis des autres composants actifs ou des portions dopées) et non pas seulement en un nitrure de silicium non stoechiométrique. De plus, le guide d'onde intégré 3 est disposé sous la photodiode 2 et non pas à côté latéralement ou au-dessus d'elle, et peut ainsi être espacé vis-à-vis de la couche épaisse 11 du substrat photonique 10 d'une distance adéquate pour limiter les pertes optiques par fuite du mode guidé dans celle-ci. Par ailleurs, comme expliqué par la suite, le fait que le guide d'onde intégré 3 soit disposé sous la photodiode 2, et non pas à côté latéralement ou au-dessus d'elle, permet de réduire les contraintes de réalisation en termes de dimensionnement, de positionnement, et de budget thermique.

Les figures 2A à 2J illustrent différentes étapes d'un procédé de fabrication du dispositif optoélectronique 1 selon un mode de réalisation, où le dispositif optoélectronique 1 est similaire à celui illustré sur la fig.1.

En référence aux fig.2A et 2B, on réalise un premier substrat dit semiconducteur 20, dans la mesure où il comporte un empilement de couches minces semiconductrices 23, 24, 25 destinées à la réalisation du plot semiconducteur 30.

On réalise tout d'abord (fig.2A) un substrat SOI ou GeOI, formé d'un empilement d'une couche support 21, ici un substrat massif en silicium, d'une couche 22 d'oxyde enterré (BOX, pour *Buried Oxide,* en anglais) qui recouvre la couche support 11 et dont l'épaisseur est de préférence égale à 145nm environ, et une couche mince semiconductrice 23 à base de silicium dont l'épaisseur est de préférence égale à 70nm. Dans cet exemple, le substrat est de type SOI et la couche mince semiconductrice 23 est réalisée en silicium monocristallin. En variante, le substrat peut être de type GeOI et la couche mince semiconductrice 23 serait alors réalisée en germanium monocristallin.

Ensuite (fig.2B), on réalise l'empilement semiconducteur par épitaxie. On réalise tout d'abord un dopage de la couche mince semiconductrice 23 par implantation ionique, par exemple au phosphore, suivi d'un recuit d'activation des dopants, pour ainsi obtenir une première couche mince dopée 23, ici réalisée en silicium dopé de type n. On réalise ensuite une couche mince intermédiaire 24 en germanium non intentionnellement dopé, par épitaxie à partir de la couche mince dopée 23, puis une deuxième couche mince 25 à base de silicium dopé de type p. Cette couche mince dopée 25 est ici réalisée en silicium et le dopage au bore est réalisé de préférence à la croissance. De préférence, une couche mince de collage 26, réalisée en un oxyde, est déposée sur la couche mince dopée 25. Notons que, à la suite de la réalisation par épitaxie de l'empilement semiconducteur, la couche mince intermédiaire 24 présente des contraintes mécaniques en tension dans le plan XY, du fait du différentiel de dilatation thermique entre le silicium et le germanium. La fréquence de coupure d'absorption de la photodiode 2 pourra alors être au moins égale à 1550nm.

En référence à la fig.2C, on réalise ensuite le substrat photonique 10. Comme indiqué précédemment, il comporte une couche support 11, par exemple un substrat massif en silicium, une couche inférieure diélectrique 12 réalisée par exemple en un oxyde, le guide d'onde intégré 3, et une couche supérieure diélectrique 13 réalisée en un oxyde. Le guide d'onde 3 appartient ici à un circuit photonique intégré situé dans le substrat photonique 10. Il peut avoir été réalisé par un dépôt chimique en phase vapeur à basse pression (LPCVD) suivi d'un recuit à haute température (de l'ordre de 1000°C). On obtient ainsi un guide d'onde intégré 3 réalisé en Si₃N₄ dont les pertes optiques en transmission sont fortement réduites. Un traitement de surface peut être effectué pour préparer le collage direct de type oxyde/oxyde du substrat semiconducteur 20 sur le substrat photonique 10.

En référence à la fig.2D, on reporte le substrat semiconducteur 20 sur le substrat photonique 10, en mettant au contact la couche mince de collage 26 sur la couche supérieure diélectrique 13. Le substrat semiconducteur 20 est alors collé au substrat photonique 10 par un collage direct ici de type oxyde/oxyde.

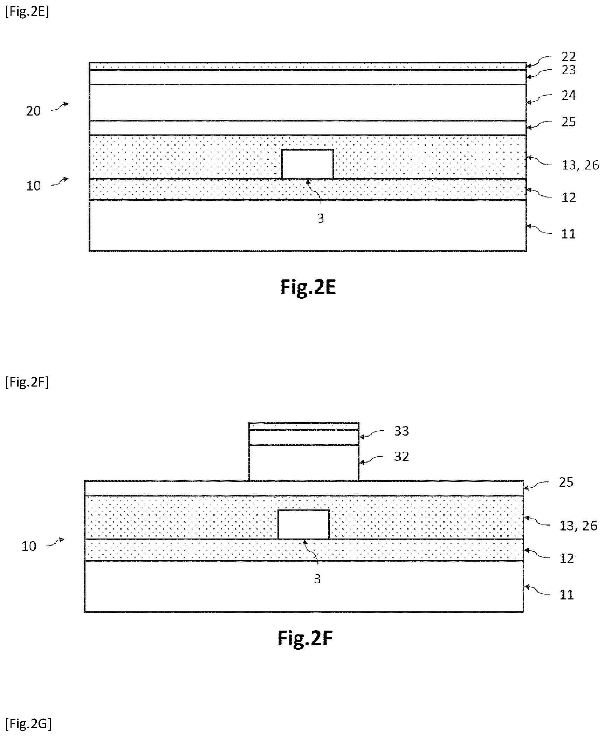

En référence à la fig.2E, on retire ou supprime la couche support 21 du substrat semiconducteur 20, par exemple par amincissement mécanique suivi d'une gravure humide à l'acide chlorhydrique. On amincit ensuite la couche 22 d'oxyde enterrée de manière uniforme sur toute sa surface.

En référence à la fig.2F, on structure la couche mince 23 dopée n et la couche intermédiaire 24 pour ainsi obtenir respectivement la portion supérieure 33 dopée n et la portion intermédiaire d'absorption 32. La structuration peut être effectuée par photolithographie et gravure localisée, par exemple par gravure sèche avec arrêt de gravure par détection de fin d'attaque sur la couche mince 25 dopée p. La portion supérieure 33 dopée n et la portion intermédiaire d'absorption 32 sont positionnées au-dessus et à la verticale du guide d'onde intégré 3 à l'aide de marques de lithographie réalisées au préalable dans le substrat photonique 10.

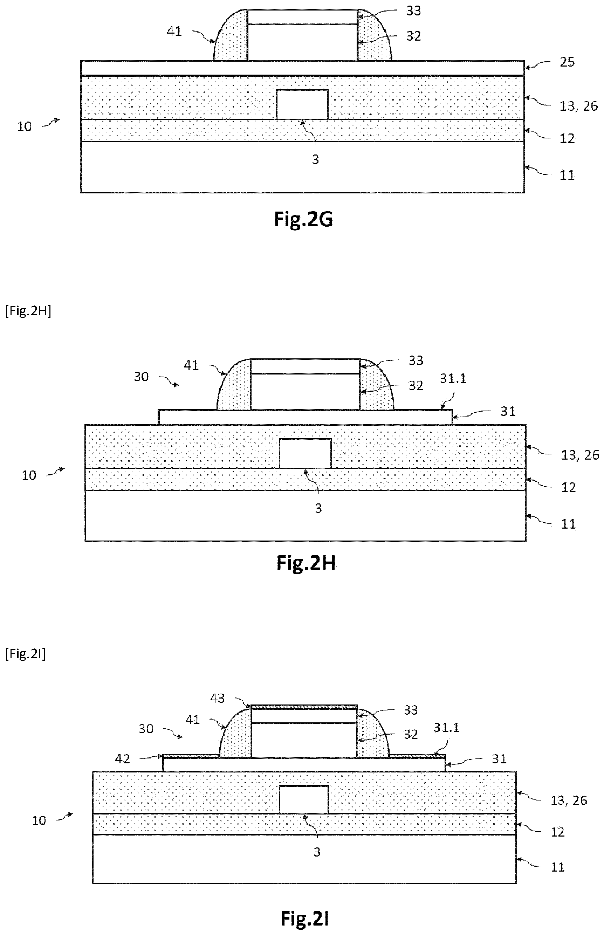

En référence à la fig.2G, on réalise des espaceurs 41 de part et d'autre de la portion intermédiaire d'absorption 32. Pour cela, on dépose de manière conforme une couche de masque dur (non représentée) en un matériau électriquement isolant, par exemple en un nitrure de silicium et/ou en orthosilicate de tétraéthyle (TEOS), de manière à recouvrir de manière continue la portion supérieure 33 dopée n et la portion intermédiaire d'absorption 32, ainsi que la couche mince 25 dopée p. Puis, on grave la couche de masque dur par une gravure sèche avec arrêt par détection de fin d'attaque sur le silicium de la portion supérieure 33 dopée n et de la couche mince 25 dopée p. On obtient ainsi deux espaceurs 41 situés contre et au contact des flancs de la portion supérieure 33 dopée n et de la portion intermédiaire d'absorption 32. La face supérieure de la portion supérieure 33 dopée n est rendue libre, ainsi qu'une surface non recouverte par les espaceurs 41 de la face supérieure de la couche mince 25 dopée p.

En référence à la fig.2H, on réalise ensuite la portion inférieure 31 dopée p. Notons que cette étape peut être réalisée avant la formation des espaceurs 41. La portion inférieure 31 dopée p peut être réalisée par lithographie et gravure de la couche mince 25 dopée p par gravure sèche avec arrêt par détection de fin d'attaque sur l'oxyde de la couche mince de collage 26. La portion inférieure 31 dopée p présente ainsi une partie centrale recouverte par la portion intermédiaire d'absorption 32 et par les espaceurs 41, et des parties latérales 31.1 non recouvertes.

En référence à la fig.2I, on réalise ensuite les portions latérales conductrices 42, et ici la portion centrale conductrice 43. Ces portions latérales 42 et centrale 43 sont avantageusement réalisées de manière simultanée dans la mesure où la portion supérieure 33 dopée n et la portion inférieure 31 dopée p sont ici réalisées toutes deux en silicium. Elles sont réalisées en un matériau électriquement conducteur. Ce matériau est de préférence un siliciure d'un métal de transition, par exemple un siliciure de nickel NiSi₂. Pour cela, à titre d'exemple, on dépose une couche mince continue de nickel Ni d'une épaisseur par exemple de 9nm, de manière à recouvrir continûment la face supérieure de la portion supérieure 33 dopée n et la face supérieure des parties latérales 31.1 de la portion inférieure 31 dopée p, puis on dépose une couche mince continue de nitrure de titane TiN d'une épaisseur par exemple de 10nm. On effectue ensuite un recuit de siliciuration pour former des zones localisées de NiSi₂ au contact de la portion supérieure 33 dopée n et des parties latérales 31.1 de la portion inférieure 31 dopée p. Une étape de gravure humide permet de supprimer les zones n'ayant pas siliciuré. On obtient ainsi les portions latérales conductrices 42 et la portion centrale conductrice 43 en NiSi₂.

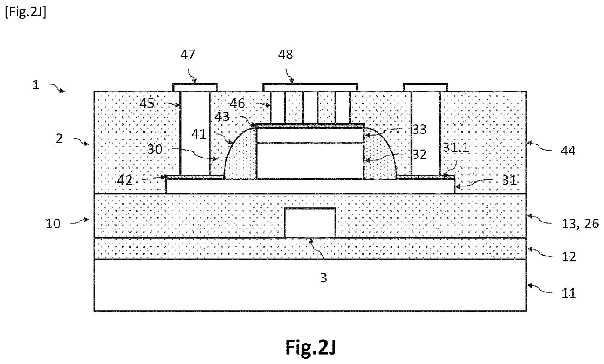

En référence à la fig.2J, on finalise la réalisation de la photodiode 2. Pour cela, on dépose une couche isolante d'encapsulation 44 de manière à recouvrir le plot semiconducteur 30 et le substrat photonique 10, suivie d'une planarisation. Des métallisations de contact sont ensuite réalisées pour assurer la polarisation électrique de la photodiode 2. Elles comportent ici des vias conducteurs latérales 45 et des vias conducteurs centraux46 qui s'étendent au travers de la couche isolante d'encapsulation 44 pour venir ici au contact, respectivement, des portions latérales conductrices 42 et de la portion centrale conductrice 43. Des plots de contact 47, 48 peuvent être réalisés sur la couche isolante d'encapsulation 44 pour faciliter la connexion électrique.

Ainsi, le procédé permet de fabriquer un dispositif optoélectronique 1 qui présente de bonnes performances, en mettant en oeuvre la réalisation puis le report et collage direct d'un substrat photonique 10 comportant le guide d'onde intégré 3 en Si₃N₄ d'une part, et un substrat semiconducteur 20 destiné à former le plot semiconducteur 30 de la photodiode 2 d'autre part. L'étape de recuit pour réduire les pertes de propagation dans le guide d'onde en Si₃N₄ est réalisée avant l'étape de report et de collage, tout comme les étapes de dopage des couches minces dopées 23 et 25. Ces substrats 10, 20 sont ainsi 'pré-fonctionnalisés' avant l'étape de report et de collage, ce qui permet ainsi de réduire les contraintes d'intégration en termes de budget thermique une fois que l'étape de report et de collage est effectuée. Le silicium de la portion inférieure 31 dopée p présente l'avantage d'assurer à la fois un arrêt de gravure lors de la réalisation de la portion supérieure 33 dopée n et de la portion intermédiaire d'absorption 32, et autorise la formation d'un siliciure améliorant le contact électrique entre la portion inférieure 31 dopée p et le via conducteur 45.

Par ailleurs, le guide d'onde intégré 3 est disposé sous la photodiode 2 et non pas à côté latéralement ou au-dessus de celle-ci, ce qui simplifie la réalisation du circuit photonique intégré. Il est couplé optiquement à la photodiode 2 de manière évanescente via une couche diélectrique intermédiaire 13, 26 d'épaisseur uniforme de quelques centaines de nanomètres environ, par exemple égale à 200nm environ. Il est enfin espacé d'une distance suffisante vis-à-vis de la couche support 11 pour limiter les fuites optiques du mode guidé, par exemple de 2 à 3µm.

Des modes de réalisation particuliers viennent d'être décrits. Différentes variantes et modifications apparaîtront à l'homme du métier.

## Revendications

1. Procédé de fabrication d'un dispositif optoélectronique (1) comportant une photodiode (2) de type germanium sur silicium couplée optiquement à un guide d'onde (3) en Si₃N₄, la photodiode (2) comportant un plot semiconducteur (30) formé d'une portion inférieure dopée (31) réalisée à base de silicium dopé selon un premier type de conductivité, une portion supérieure (33) dopée selon un deuxième type de conductivité opposé au premier type et réalisée à base de silicium et/ou de germanium, et est de préférence réalisée en silicium, et une portion intermédiaire d'absorption (32) réalisée à base de germanium et située entre les portions inférieure et supérieure dopées (31, 33) suivant un axe d'épaisseur de la photodiode (2), le procédé étant **caractérisé en ce qu'**il comporte les étapes suivantes :
o réalisation d'un substrat dit semiconducteur (20), comportant un empilement semiconducteur de couches minces (23, 24, 25) destinées à former les portions (31, 32, 33) du plot semiconducteur (30) ;
o réalisation d'un substrat dit photonique (10), comprenant une couche support (11) et comportant le guide d'onde (3) en Si₃N₄; la réalisation dudit substrat comprenant une étape de réalisation du guide d'onde (3) en un nitrure de silicium stoechiométrique Si3N4, suivie d'une étape de recuit du guide d'onde (3) au moins égale à 1000°C ;
∘ report et collage du substrat semiconducteur (20) sur le substrat photonique (10) postérieurement à l'étape de recuit;
∘ réalisation de la photodiode (2), par photolithographie et gravure de l'empilement semiconducteur (23, 24, 25) pour former le plot semiconducteur (30) alors situé au-dessus du guide d'onde (3).

2. Procédé de fabrication selon la revendication 1, comportant, lors de l'étape de réalisation de la photodiode (2), une étape de réalisation de la portion supérieure dopée (33) et de la portion intermédiaire d'absorption (32), par gravure localisée d'une couche mince supérieure dopée (23) et d'une couche mince intermédiaire (24) réalisée à base de germanium de l'empilement semiconducteur, avec arrêt de gravure sur une couche mince inférieure dopée (25) de l'empilement semiconducteur destinée à former la portion inférieure dopée (31).

3. Procédé de fabrication selon la revendication 2, comportant, après l'étape de réalisation de la portion supérieure dopée (33) et de la portion intermédiaire d'absorption (32), une étape de réalisation d'espaceurs (41) réalisés à base d'un matériau électriquement isolant, disposés contre les flancs de la portion intermédiaire d'absorption (32), et s'étendant sur une partie de la couche mince inférieure dopée (25) ou de la portion inférieure dopée (31).

4. Procédé de fabrication selon la revendication 2 ou 3, comportant, après l'étape de réalisation de la portion supérieure dopée (33) et de la portion intermédiaire d'absorption (32), une étape de réalisation de la portion inférieure dopée (31), par gravure localisée d'une couche mince inférieure dopée (25), de sorte que la portion inférieure dopée (31) présente des parties latérales (31.1) non recouvertes.

5. Procédé de fabrication selon la revendication 4, comportant, après l'étape de réalisation de la portion inférieure dopée (31), une étape de réalisation de portions latérales conductrices (42), réalisées en un matériau électriquement conducteur, situées sur et au contact d'une face supérieure des parties latérales (31.1) de la portion inférieure dopée (31), par siliciuration du matériau à base de silicium de la portion inférieure dopée (31).

6. Procédé de fabrication selon la revendication 5, comportant une étape de réalisation d'une portion centrale conductrice (43), réalisée en un matériau électriquement conducteur, située sur et au contact d'une face supérieure de la portion supérieure dopée (33), celle-ci étant réalisée à base de silicium, par siliciuration du matériau à base de silicium de la portion supérieure dopée (33) de manière simultanée à la siliciuration du matériau à base de silicium de la portion inférieure dopée (31).

7. Procédé de fabrication selon la revendication 4 ou 5, comportant une étape de dépôt d'une couche isolante d'encapsulation (44) recouvrant le plot semiconducteur (30), puis une étape de réalisation de métallisation de contact comportant des vias conducteurs latéraux (45) traversant la couche isolante d'encapsulation (44) pour venir au contact des portions latérales conductrices (42).

8. Procédé de fabrication selon l'une quelconque des revendications précédentes, comprenant une étape de recouvrement de la couche support (11) par une couche inférieure diélectrique (12) qui présente une épaisseur d'au moins 2 µm pour éviter les fuites optiques en direction de la couche support (11).

9. Dispositif optoélectronique (1), comportant :
o une photodiode (2) de type germanium sur silicium, comportant un plot semiconducteur (30) formé d'une formé d'une portion inférieure dopée (31) réalisée à base de silicium, une portion supérieure dopée (33), et une portion intermédiaire d'absorption (32) réalisée à base de germanium et située entre les portions inférieure et supérieure dopées (31, 33) suivant un axe d'épaisseur de la photodiode (2) ;
∘ un guide d'onde (3) en Si₃N₄, intégré et couplé optiquement à la photodiode (2) ;
∘ **caractérisé en ce que** le guide d'onde (3) est situé en dessous de la photodiode (2) suivant un axe d'épaisseur de la photodiode (2), et est intégré dans un substrat photonique (10) sur lequel repose la photodiode (2) ;
le dispositif comprenant :
∘ une couche supérieure diélectrique (13) qui recouvre le guide d'onde intégré (3) ainsi qu'une couche inférieure diélectrique (12) sur laquelle repose le guide d'onde (3),
∘ de sorte que
∘ le guide d'onde (3) est couplé optiquement à la photodiode (2) de manière évanescente via la couche diélectrique intermédiaire (13).

10. Dispositif optoélectronique (1) selon la revendication 9, dans lequel le substrat photonique (10) comporte une couche support (11) et la couche inférieure diélectrique (12) sur laquelle repose le guide d'onde (3), le guide d'onde (3) étant espacé de la couche support (11) d'au moins 2µm.

11. Dispositif optoélectronique (1) selon la revendication 9 ou 10, dans lequel la portion inférieure dopée (31) présente une dimension transversale supérieure à celle de la portion intermédiaire d'absorption (32), des espaceurs (41) réalisés à base d'un matériau électriquement isolant, disposés contre les flancs de la portion intermédiaire d'absorption (32), et s'étendant sur une partie de la face supérieure de la portion inférieure dopée (31).

12. Dispositif optoélectronique (1) selon la revendication 11, comportant des portions latérales conductrices (42), réalisées en un siliciure, situées sur et au contact d'une face supérieure de parties latérales (31.1) de la portion inférieure dopée (31) non recouvertes par les espaceurs (41).

13. Dispositif optoélectronique (1) selon l'une quelconque des revendications 9 à 12, dans lequel la portion supérieure dopée (33) est réalisée à base de silicium, et comportant une portion centrale conductrice (43), réalisées en un siliciure, située sur et au contact d'une face supérieure de la portion supérieure dopée (33).

14. Dispositif optoélectronique (1) selon les revendications 12 et 13, comportant une couche isolante d'encapsulation (44) recouvrant le recouvrant le plot semiconducteur (30) et les portions latérales et centrale conductrices (42, 43), et des métallisation de contact comportant des vias conducteurs latéraux (45) traversant la couche isolante d'encapsulation (44) pour venir au contact des portions latérales conductrices (42), et au moins un via conducteur centrale (46) traversant la couche isolante d'encapsulation (44) pour venir au contact de la portion centrale conductrice (43).
